## Europäisches Patentamt
## European Patent Office
## Office européen des brevets

(19)

(11) Numéro de publication: **0 151 653**
**B1**

(12)

# FASCICULE DE BREVET EUROPEEN

(45) Date de publication du fascicule du brevet:
**16.09.87**

(51) Int. Cl.⁴: **G 06 F 11/26**, G 06 F 5/00, H 03 M 9/00

(21) Numéro de dépôt: **83430040.2**

(22) Date de dépôt: **15.12.83**

(54) **Dispositif de sérialisation/désérialisation de configuration de bits de longueur variable.**

(43) Date de publication de la demande:
**21.08.85 Bulletin 85/34**

(45) Mention de la délivrance du brevet:
**16.09.87 Bulletin 87/38**

(84) Etats contractants désignés:
**DE FR GB**

(56) Documents cités:
**EP - A - 0 104 293**
**DE - A - 2 625 183**
**US - A - 4 312 066**
**US - A - 4 326 290**

**1979 IEEE TEST CONFERENCE, DIGEST OF PAPERS, 23-25 octobre 1979, session 2, LSI & Boards, Cherry Hill, N.J. (US) L.A. STOLTE et al.:"Design for testability of the IBM system/38", pages 29-36**
**IBM TECHNICAL DISCLOSURE BULLETIN, vol. 19, no. 1, juin 1976, New York (US) T. STRANKO et al.:"Selective ring modification with check pattern", pages 169-170**

(73) Titulaire: **International Business Machines Corporation, Old Orchard Road, Armonk, N.Y. 10504 (US)**
(84) Etats contractants désignés: **DE GB**

(73) Titulaire: **Compagnie IBM FRANCE, 5 Place Vendôme, F-75000 Paris 1er (FR)**
(84) Etats contractants désignés: **FR**

(72) Inventeur: **Duforestel, Guy Gaston, 58, Chemin Pont des Colles, F-06610 La Gaude (FR)**
Inventeur: **Lechaczynski, Michel André, 17, Avenue Georges Clémenceau, F-06000 Nice (FR)**
Inventeur: **Poiraud, Clément Yvon, 19, Chemin du Malvan, F-06800 Cagnes/Mer (FR)**
Inventeur: **Viallon, Paul Pierre, 401, Chemin des Aspras, F-06140 Vence (FR)**

(74) Mandataire: **Lattard, Nicole, Compagnie IBM France Département de Propriété Intellectuelle, F-06610 La Gaude (FR)**

ACTORUM AG

**Description**

La présente invention concerne un dispositif de sérialisation/désérialisation pour charger/ou lire des configurations de bits dans/ou d'une chaîne de bascules de longueur variable, pouvant être particulièrement utilisé pour charger et lire les chaînes de bascules constituées dans une unité de traitement de données, pour l'initialisation et le test de la machine.

Ainsi qu'il est déscrit dans l'article paru dans la revue «Electronics» du 15 Mars 1979 aux pages 108 à 110, l'intégration de plus en plus poussée des circuits logiques composant les machines impose de concevoir ces circuits de façon que le test en soit possible aux différents stades de la réalisation: conception et fabrication et ultérieurement lorsque la machine est installée et qu'il faut localiser les pannes. La conception des circuits logiques du type LSSD (Level Sensitive Scan Design) décrite dans cet article facilite le test des circuits de même que l'initialisation des machines.

Dans les machines conçues suivant la technique LSSD, les circuits logiques sont intégrés dans des microplaquettes (chips) assemblées sur des cartes elles-mêmes enfichées sur des panneaux.

Ainsi qu'il est décrit dans l'article, le test de la machine ou son initialilsation nécessite le chargement et la lecture de configuration de bits dans des chaînes de bascules constituant des registres à décalage. Chaque bascule du type SRL (Shift Register Latch) est constituée de deux bascules élémentaires L1, L2 connectées comme divulgué dans l'article.

Les machines sont conçues de telle sonte que toute unité RU puisse être testée et remplacée si elle est trouvée défectueuse. Pour cela, les circuits logiques de la machine sont conçus pour que chaque unité qui peut être une microplaquette ou une carte, comporte au moins une chaîne de bascules connectées en série en mode LSSD pour le test ou pour l'initialisation de la machine.

En conséquence, les différentes chaînes sont de longueur variable suivant l'unité dans laquelle elles se trouvent.

Par exemple, les machines constituées conformément à cette technique LSSD, telles que le processeur IBM 3081, le système IBM 38, comportent un processeur de service et une unité de traitement centrale dont les différentes chaînes peuvent être chargées à partir de la mémoire du processeur de service dans laquelle les configurations de bits de test ou d'initialisation sont stockées.

Ces configurations sont chargées dans les différentes chaînes lors des procédures de diagnostic pour réaliser le test ou lors des procédures d'initialisation de la machine sous contrôle du programme du processeur de service. EP-A-0 104 293 [relevant de l'article 54 (3) CBE] décrit un dispositif pour le chargement et la lecture de telles chaînes.

Les documents suivants: l'article «Design of Testability of the IBM System/38» paru dans 1979 IEEE Test Conference Digest of Papers, 23-25 Oct. 1979, pages 29 à 36 et la revue IBM Journal of Research and Development, Vol. 26, No. 1, Janvier 1982, décrivent un type d'environnement dans lequel le dispositif de l'invetion peut être utilisé.

Un problème se pose pour le chargement des chaînes LSSD: la mémoire du processeur de service est organisée en multiplets de longueurs fixes, et la configuration de bits à charger dans chaque chaîne comporte un nombre de bits qui est un multiple de la longueur du multiplet plus un nombre de bits résiduels (qui sera appelé résidu) inférieur au nombre de bits d'un multiplet.

En conséquence, le chargement des configurations de bits dans les diverses chaînes ne peut se faire de façon simple, du fait que le nombre de bits du résidu est variable. Il faut donc que le sérialiseur/désérialiseur soit capable d'effectuer un nombre de décalages variable en fonction du nombre de bits du résidu et il faut que le programme gère ce nombre de décalages. De ce fait l'opération de sérialisation/désérialisation ne peut être réalisée à l'aide de registres à décalage simples. De plus le programme de commande du processeur de service est rendu compliqué par les opérations de gestion du nombre de décalage.

Un objet de la présente invention est donc de réaliser un sérialiseur/désérialiseur dans lequel le nombre des décalages est constant quelque soit le nombre de bits à envoyer ou à recevoir.

*Résumé de l'Invention*

La présente invention concerne un dispositif de sérialisation/désérialisation pour charger ou lire des configurations de bits dans des/ou de chaînes de bascules de longueur variable égale à nk + r, où n est le nombre de bits d'un multiplet, k est le nombre de multiplets entiers de la chaîne et r est le nombre de bits résiduels inférieur à n. Il comprend un registre à décalage sérialiseur/déserialiseur SERDES comportant n bascules qui peuvent être chargées ou lues en parallèle. Un registre d'extension ayant un nombre maximum de (n-1) bascules et des moyens de sélection pour constituer dans ce registre d'extension un registre à décalage dont le nombre de bascules dépend de la longueur de la chaîne et est égal à (n-r). Lors d'une opération de chargement ou de lecture, les bascules du registre SERDES, les bascules de la chaîne considérée et les bascules sélectionnées du registre d'extension sont reliées en un anneau. Une opération de chargement est réalisée en chargeant en parallèle dans le registre SERDES le multiplet comportant les bits résiduels et en provoquant un décalage de n bits dans l'anneau, puis en chargeant successivement les k multiplets et en provoquant après chaque chargement un décalage de n bits de sorte qu'après k + 1 décalage de n bits, la configuration de bits désirée est chargée dans la chaîne.

Une opération de lecture est réalisée, en provoquant un premier décalage de n bits dans l'anneau, en lisant le contenu des bascules du registre SERDES, en provoquant les décalages successifs de n bits et en lisant après chaque décalage le contenu du registre SERDES.

Le dispositif peut être utilisé pour charger et lire les chaînes de bascules constituées dans une unité de traitement de données pour réaliser les opérations d'initialisation et de test. Dans cette application, les configurations de bits à charger dans chacune des chaînes sont stockées dans la mémoire d'un microprocesseur, dans laquelle une zone est affectée à chaque chaîne. Chaque zone comporte en plus de la configuration de bits arrangées en multiplets, le nombre de bits résiduels codé en binaire.

Pour réaliser une opération de chargement ou de lecture, le microprocesseur envoie le nombre de bits résiduels au moyen de sélection pour constituer le registre à décalage comportant (n-r) bascules du registre d'extension, adresse la chaîne à sélectionner pour l'inclure dans l'anneau comprenant les bascules sélectionnées du registre d'extension et le registre SERDES.

Pour une opération de chargement, le microprocesseur envoie successivement par des opérations d'écriture, le multiplet comportant les bits résiduels puis les k multiplets entiers et contrôle l'application après chaque opération d'écriture, d'un nombre d'impulsions d'horloge aux bascules de l'anneau pour provoquer des décalages de n bits.

Pour une opération de lecture, le microprocesseur contrôle l'application d'un nombre d'impulsions d'horloge aux bascules de l'anneau pour provoquer un décalage de n bits puis par une opération de lecture lit le contenu du registre SERDES, et contrôle ensuite k décalages de n bits, chaque décalage étant suivi par la lecture du registre SERDES.

*Brève Description des Figures*

La fig. 1 représente le dispositif de sérialisation/désérialisation,

la fig. 2 représente une bascule SRL qui peut être utilisée pour constituer les registres 14, 16 et les chaînes 3 et 4 du dispositif de la fig. 1,

les figures 3 A-E et 4 A-D représentent les contenus des bascules du dispositif de la fig. 1 au cours d'une opération d'écriture et d'une opération de lecture respectivement,

la fig. 5 représente le circuit de sélection 24 et le registre d'extension 16 de la fig. 1.

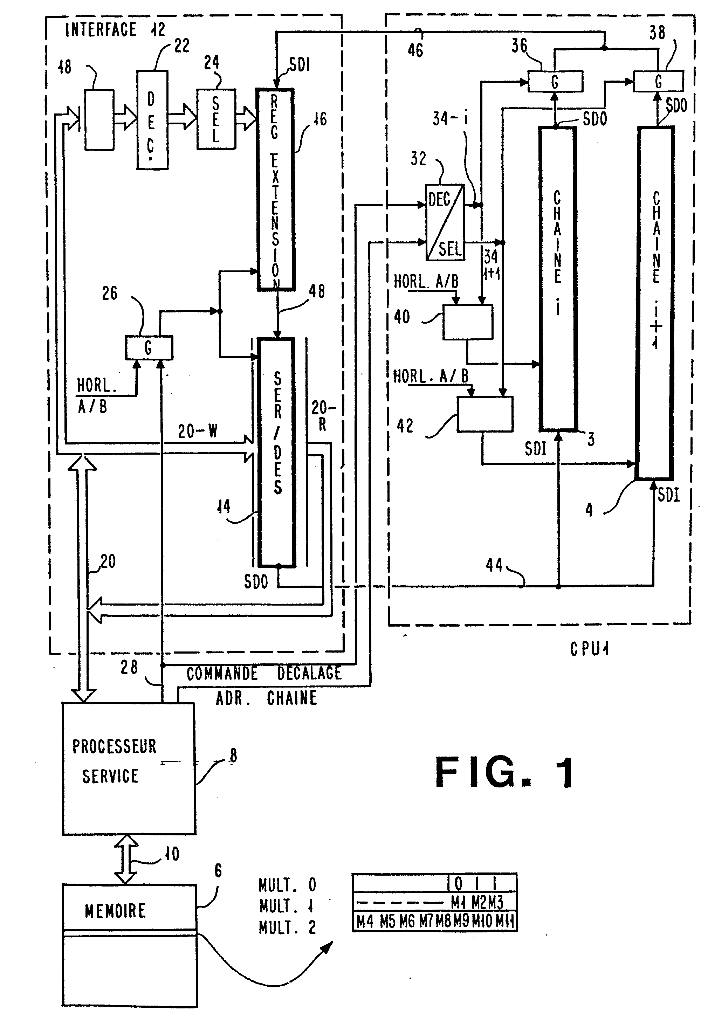

Le sérialiseur/désérialiseur de la présente invention est représenté sur la fig. 1. On suppose que les chaînes à charger ou à lire se trouvent dans une unité de traitement centrale CPU 1. On a représenté à titre d'exemple deux chaînes i et i+1, 3 et 4. Chaque chaîne a une longueur nk + r, par exemple, chaîne i = longueur $n k_i + r_i$, chaîne i+1 = longueur $n k_{i+1} + r_{i+1}$; où n est le nombre de bits des multiplets de données dans le type de machine considérée généralement 8, $k_i$ et $k_{i+1}$ sont des entiers supérieurs ou égaux à 0 et $r_i$ et $r_{i+1}$ sont les nombres de bits des résidus, inférieurs à n, pour les chaînes i et i+1, respectivement.

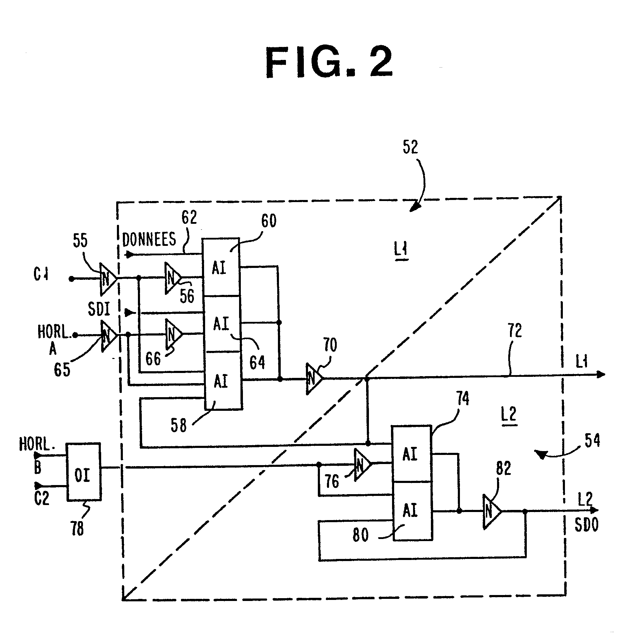

Ces chaînes sont constituées de bascules type SRL qui peuvent être du type décrit dans l'article ci-dessus référencé. Une telle bascule est représentée sur la fig. 2.

Les configurations de bits à charger dans chaque chaîne, suivant l'opération à réaliser: test ou chargement initial, sont stockés dans la mémoire 6 attachée au processeur de service 8 par bus 10.

Le sérialiseur/désérialiseur se trouve dans l'interface logique 12 entre le processeur de service 8 et le CPU 1. Il comporte deux registres à décalage 14 et 16 eux aussi constitués de bascules SRL du même type. Le premier registre de sérialisation/désérialisation SERDES 14 a un nombre de positions n, égal au nombre n de bits des multiplets à traiter généralement 8 bits et le second registre d'extension 16 a (n-1) positions.

L'interface comporte en outre un registre 18 qui reçoit du processeur de service par le bus d'entrée/sortie 20 du processeur le nombre de bits du résidu de la chaîne à charger ou à lire pour une opération donnée. La valeur du résidu est décodé dans le circuit de décodage 22 et utilisé par un circuit de sélection 24 pour constituer dans le registre 16, une chaîne de bacules qui est variable suivant le nombre de bits du résidu, d'une façon qui sera décrite ultérieurement.

Le registre 14 est chargé par le processeur de service, par le bus 20-W, et peut être lu par le bus 20-R.

Une porte G 26 ouverte sous contrôle du processeur de service 8 par un signal de commande de décalage sur la ligne 28, laisse passer les impulsions d'horloge A et B et les applique aux bascules des deux registres 14 et 16 sur leurs entrées Horloge A et Horloge B (voir fig. 1).

Lorsque une opération de chargement ou de lecture d'une chaîne d'adresse choisie est à réaliser, le processeur de service 8 envoie sur le bus d'adresse 30, la configuration des bits d'adresse de la chaîne sélectionnée et un signal de commande sur la ligne 28, au circuit de décodage et de sélection 32.

Le circuit de décodage et de sélection 32 a deux sorties 34-i et (i + 1).

Les sorties 34-i et 34-(i + 1) lorsqu'elles sont actives ouvrent les portes G 36 et 38, connectées aux sorties SDO des dernières bascules des chaînes 3 et 4 respectivement.

La sortie 34-i est aussi connectée à une porte 40, pour laisser passer les impulsions d'horloge A/B lorsque la chaîne 3 et sélectionnée et appliquer ces impulsions aux entrées d'horloge A et B des bascules de la chaîne 3.

De la même façon la sortie 34-(i + 1) est connectée à une porte 42 pour laisser passer les impulsions d'horloge A/B lorsque la chaîne 4 est sélectionnée et appliquer ces impulsions aux entrées d'horloge A et B des bascules de la chaîne 4.

Lorsque les impulsions d'horloge sont appliquées aux bascules des registres 14 et 16 et d'une chaîne sélectionnée, un registre en anneau est constitué par les bascules des registres 16 et 14, et les bascules de la chaîne sélectionnée. Pour cela la sortie SDO de la dernière bascule du registre 14 est reliée à l'entrée SDI de la première bascule des chaînes 3 et 4 par la ligne 44 et les sorties des portes 36 et 38 sont connectées à l'entrée SDI de la première bascule du registre d'extension 16 par la ligne 46. La sortie SDO de la dernière bascule du registre 16 est connectée à l'entrée SDI de la première bascule du registre 14 par la ligne 48.

La configuration de bits destinées à chaque chaîne pour les diverses opérations test ou initialisation sont stockées dans la mémoire 8 comme représenté sur la fig. 1. Le multiplet 0 contient le nombre de bits r du résidu codé en binaire sur trois bits dans l'exemple choisi où n = 8, par exemple 011, le multiplet 1 contient les bits du résidu M1, M2, M3 et les autres multiplets contiennent la suite de la configuration M4 à M11 multiplet 2, les multiplets entiers, dans le cas d'une configuration plus longue peuvent être contenus à la suite.

Chaque étage comprenant une bascule SRL représenté sur la fig. 2. Elle comporte deux bascules élémentaires L1 et L2, 52, 54 respectivement chacune constitué de circuit ET-INVERSEUR AI et d'inverseur N.

Ces deux bascules L1 et L2 qui ne seraient pas forcément nécessaires, toutes les deux, en mode normal, le sont obligatoirement pour constituer une chaîne dans la machine.

La bascule SRL 50, lorsqu'elle fonctionne en mode normal est enclenchée et restaurée par des horloges C1 et C2. L'horloge C1 est appliquée à un inverseur 55 qui est connecté à un autre inverseur 56 et à un circuit ET inverseur AI 58.

La sortie de l'inverseur 56 est appliquée à un circuit AI 60 qui reçoit aussi en mode normal (non LSSD; NON initialisation, NON test) le bit de donnée à charger, par la ligne 62. Dans les 8 bascules du registre 14, ces entrées sont connectées aux fils du bus 20-W.

Le signal SDI (Scan Data In) d'une bascule L2 54 d'un étage précédent est appliqué à un circuit AI 64. Le signal d'horloge A est appliqué par le processeur de service à l'inverseur 65 dont la sortie est connectée à l'inverseur 66 et au circuit AI 58. Les sorties des circuits AI 60, 64 et 58 sont connectés à un inverseur 70 dont la sortie 72 constitue la sortie L1 de la bascule L1 52. La sortie de l'inverteur 70 est aussi appliquée au circuit AI 58.

La sortie de l'inverseur 70 est appliquée à un circuit AI·74 de la bascule L2 54. Ce circuit 74 a aussi une entrée connectée à la sortie de l'inverseur 76. L'entrée de cet inverseur 76 est constitué par la sortie d'un circuit OU inverseur OI 78. Le circuit 78 reçoit le signal d'horloge C2 utilisé en mode normal et le signal d'horloge B utilisé en mode LSSD. La sortie du circuit OI 78 est aussi appliquée à un circuit AI 80. Les sorties des circuits AI 74 et 80 sont appliquées à un inverseur 82 dont la sortie est la sortie L2 de la bascule L2 54 constituant la sortie SDO allant à l'entrée SDI de la bascule SRL suivante pour constituer une chaîne LSSD.

En mode normal, les bits emmagasinés dans les bascules L1 et L2 52 et 54, lorsque les horloges C1 et C2 ont été appliquées, sont les mêmes.

Cependant en mode LSSD, lorsque la bascule SRL constitue un étage d'un registre à décalage les impulsions d'horloger C1 et C2 ne sont plus appliquées mais les impulsions d'horloge A sont appliquées à la bascule L1 52 et les impulsions d'horloge B sont appliquées à la bascule L2 54, pour provoquer le décalage des bits dans la chaîne constituée entre l'entrée SDI d'une première bascule et la sortie SDO de la dernière bascule de la chaîne.

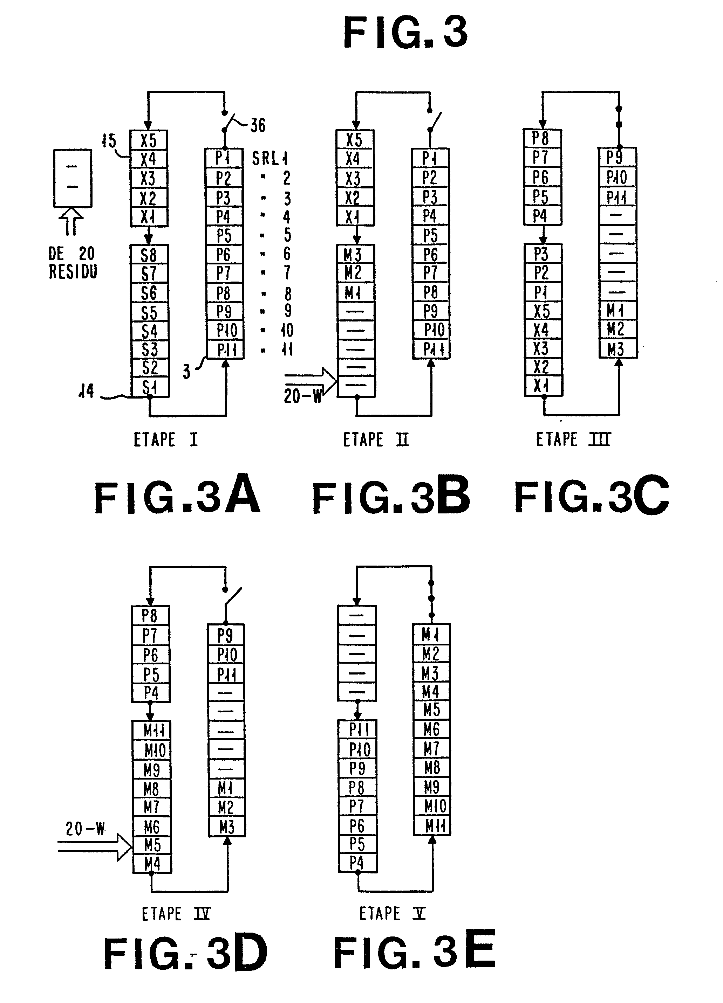

On va maintenant décrire en référence aux figures 1 et 3 une opération de chargement d'une chaîne, par exemple la chaîne 3, avec la configuration des 11 bits M1 à M11 représentée sur la fig. 1.

*Etape I:*

Le processeur de service 8, envoie dans le registre 18 par une opération PIO 1 d'entrée/sortie initialisée par le programme de commande, le nombre de bits du résidu, à savoir 011 dans l'exemple choisi, stocké dans le multiplet 0, de la zone mémoire attribuée à la chaîne 3 pour l'opération considérée test ou initialisation. Les circuits de décodage et de sélection 22 définissent dans le registre 16 une chaîne de cinq bascules (8-3) qui sont connectées en série dans dans l'anneau comprenant le registre 14 et les bascules de la chaîne sélectionnée. L'adresse de la chaîne à sélectionner est envoyée sur le bus 30.

Le contenu des bascules de l'anneau ainsi constitué est représenté sur la fig. 3A.

*Etape II:*

Pour une seconde opération PIO 2, le multiplet 1 est chargé en parallèle dans le registre 14, par le bus 20-W, dont les fils sont connectés aux entrées DONNEES des bascules du registre. Le contenu des bascules de l'anneau est représenté sur la fig. 3B.

*Etape III:*

Le processeur de service envoie une commande de décalage de 8 bits sur la ligne 28, qui fait que les portes 26 et 40 laissent passer 8 impulsions d'horloge A et B et que la porte 36 est fermée. Le contenu des bascules de l'anneau est représenté sur la fig. 3 C. On peut voir que les trois bits du résidu sont introduits dans les trois dernières bascules de la chaîne 3, SRL 9, SRL 10 et SRL 11.

*Etape IV:*

Par une troisième opération PIO 3, le multiplet 2 (M4 à M11) est chargé en parallèle dans le registre 14. Les portes 36 et 40 sont ouvertes et le contenu des bascules de la chaîne est représenté sur la fig. 3D.

*Etape V:*

Une nouvelle commande de décalage de 8 bits est envoyée sur la ligne 28 par le processeur de service. Les portes 26, 40 et 36 sont fermées et 8 impulsions d'horloge A et B sont appliquées aux bascules de l'anneau dont les contenus sont représentés sur la fig. 3E. On peut voir sur cette figure que les 11 bits M1 à M11 ont été introduits dans la chaîne 3, en ne réalisant que des décalages de 8 bits.

Si la chaîne avait été plus longue et que d'autres multiplets complets avaient dû être transmis, il aurait suffit de charger ces multiplets dans le registre 14 et après chaque chargement de faire un décalage de 8 bits.

Le registre d'extension 16 doit toujours comporter un nombre de positions qui permet au dernier décalage de 8 bits d'éliminer de la chaîne sélectionnée les bits non significatifs contenus dans le multiplet 1.

Dans le cas où la chaîne comporte k multiplets de n bits plus un résidu de r bits, l'opération de chargement de la chaîne est réalisée en constituant un registre d'extension 16 de n-r bits.

En chargeant le multiplet 1 contenant les bits du résidu dans le registre 14 de n positions, et en faisant un décalage de n bits.

En chargeant successivement les k multiplets suivants dans le registre 14 et en faisant après chaque chargement un décalage de n bits.

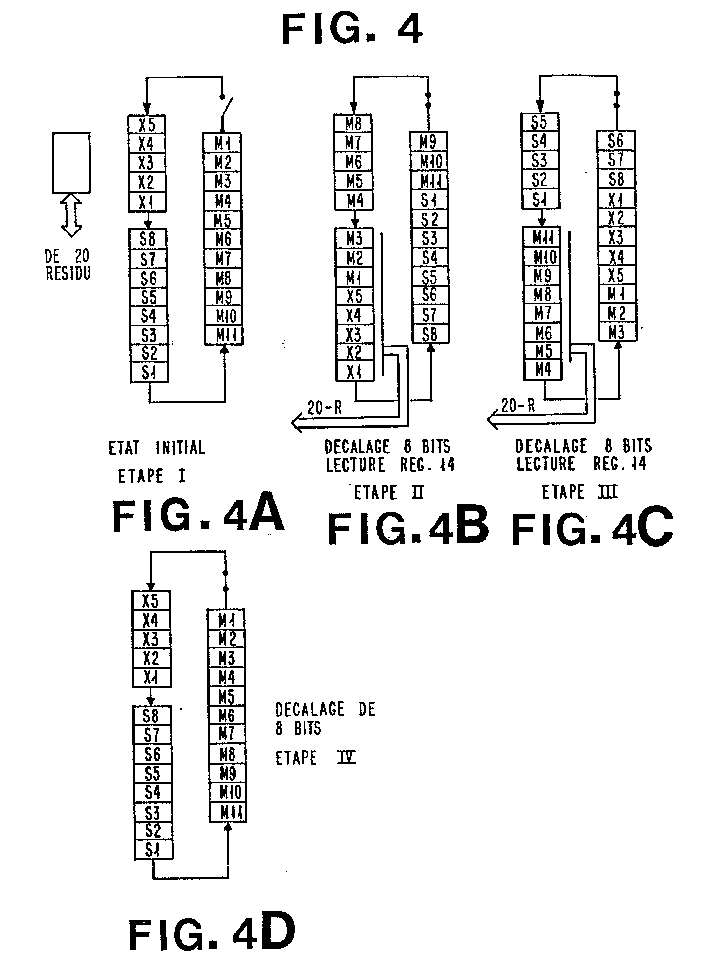

Les figures 4 A-D représentent les différentes étapes nécessaires pour réaliser une opération de lecture d'une chaîne sélectionnée par exemple la chaîne 3 de longueur 11 bits.

*Etape I:*

Le processeur de service envoie à l'étape 1, le multiplet 0 de la zone de mémoire affectée à la chaîne sélectionnée, dans le registre 18 pour constituer un registre d'extension dont la longueur dépend de la valeur du résidu, soit un registre de cinq positions dans l'exemple considéré. L'adresse de la chaîne sélectionée est envoyée sur le bus 30. Au cours des différentes opérations un anneau sera constitué entre les bascules du registre d'externsion 16, du registre 14 et de la chaîne sélectionnée dont le contenu initial est représenté sur la fig. 4A.

*Etape II:*

Ensuite un décalage de 8 bits est réalisé dans l'anneau, les portes 26, 36 et 40 étant fermées par le signal de commande de décalage envoyé sur le fil 28. A la fin du décalage, une opération de lecture PIO 1 du registre 14 est réalisée et le contenu des bascules du registre 14 (représenté sur la fig. 4B) est envoyé au microprocesseur par le bus 20-R.

*Etape III:*

Un second décalage de 8 bits est réalisé, et le contenu du registre 14 à la fin du décalage est lu par le microprocesseur par une seconde opération de lecture PIO 2.

*Etape IV:*

Un décalage supplémentaire de 8 bits peut être réalisé pour reconstituer dans la chaîne sélectionnée les valeurs initiales, de façon que la configuration de bits dans cette chaîne ne soit par détruite (fig. 4D).

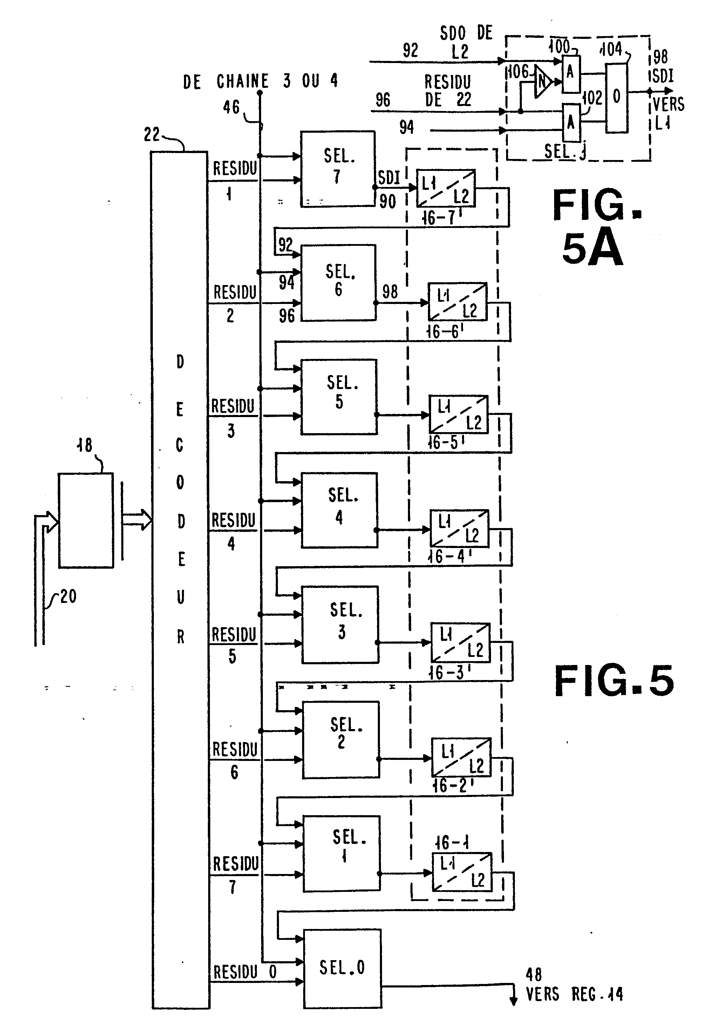

Le circuit 24 permettant de constituer un registre d'extension ayant le nombre d'étages nécessaires en focntion de la valeur du résidu est représenté sur la fig. 5.

La valeur du résidu de la chaîne sélectionnée pour une opération de chargement ou de lecture est écrite dans le registre 18. Cette valeur est décodée de façon classique par le décodeur 22, qui comporte des générateurs de valeur vraie/complément et des portes ET connectées aux sorties des générateurs pour que le niveau sur chacune des lignes de sortie R0 à R7 du décodeur indique la valeur du résidu. Par exemple, un niveau haut sur la ligne de sortie R3 indique que le résidu était de 3 bits, les niveaux sur toutes les autres lignes de sortie sont bas.

Sept circuits de sélection SEL 0 à SEL 7 sont connectés aux sorties du décordeur. Le schéma logique d'un circuit de sélection est représenté sur la fig. 5A.

La sortie R0 est connectée au circuit SEL 0, la sortie R7 est connectée au circuit SEL 1, R6 au circuit SEL 2 etc... et la sortie R1 au circuit SEL 7.

Le registre 16 comporte sept bascules SRL telle que représentée sur la fig. 2. L'entrée SDI de la bascule 16-7 est connectée à la sortie 90 du circuit de sélection SEL 7 et la sortie SDO de cette même bascule est connectée à une entrée 92 du circuit SEL 6. Chacune des bascules est disposée de la même façon par rapport à son circuit de sélection associée.

Une autre entrée 94 de chacun des circuits de sélection est connectée à la ligne 46 pour constituer au moment d'une opération de chargement ou de lecture d'une chaîne sélectionnée, l'anneau représenté sur les figures 3 et 4.

Pour le circuit de SEL 6, l'entrée 96 est connectée à la sortie R2 du décodeur 22, et la sortie 98 est connectée à l'entrée SDI de la bascule 16.6.

Chaque circuit de sélection comporte deux portes ET 100 et 102, une porte OU 104 et un inverseur 106.

La porte ET 102 est connectée aux entrées 96 et 94. La porte ET 100 est connectée à l'entrée 92 et à l'entrée 96 par l'intermédiaire de l'inverseur 106.

Les sorties des portes ET 100 et 102 sont connectées aux entrées de la porte OU 104 dont la sortie constitue la sortie 96 du circuit de sélection.

Le fonctionnement du circuit est le suivant. On va supposer que le résidu dans le registre 18 est 010. La ligne R2 à la sortie du décodeur est au niveau haut toutes les autres lignes de sortie sont au niveau bas.

La porte ET 102 dans le circuit SEL 6 est donc ouverte et les bits de données sur l'entrée 94, venant de la chaîne sélectionnée sont transmis à la sortie 98. Dans les autres circuits de sélection SEL 5 à SEL 0, la porte 102 est fermée mais la porte 100 est ouverte de telle sorte que les bascules 16.5 à 16.1 sont disposées en série pour stocker et décaler les bits sur la ligne 46, lorsque les signaux d'horloge sont appliqués aux bascules de l'anneau.

Lorsque le résidu est 0, aucune des bascules du registre 16 n'est sélectionnée et les bits sur la ligne 46 sont appliquées directement à la première bascule du registre 14.

Le dispositif de sérialisation/désérialisation a été décrit dans une machine conçue en utilisant la technique LSSD car dans une telle machine, les opérations de chargement et de lecture des chaînes LSSD sont très utilisées et nécessitent une sérialisation des bits contenus en mémoire pour les charger dans les chaînes sélectionnées et une désérialisation des bits lues des chaînes sélectionnées pour les ranger en mémoire. Il est cependant évident que ce dispositif peut être utilisé dans toutes les applications où des registres de longueur variable doivent être chargés ou lus.

**Revendications**

1. Dispositif de sérialisation/désérialisation pour charger des configurations de bits dans des chaînes de bascules de longueur variable égale à nk + r, où n est le nombre de bits d'un multiplet, k est le nombre de multiplets entiers de la chaîne et r est le nombre de bits résiduels inférieur à n, caractérisé en ce qu'il comprend:

un registre à décalage sérialiseur/désérialiseur SERDES (14) comportant n bascules qui peuvent être chargées en parallèle,

un registre d'extension (16) ayant un nombre maximum de (n-1) bascules,

des moyens de sélection (18, 22, 24) pour constituer dans le registre d'extension un registre à décalage dont le nombre de bascules dépend de la longueur de la chaîne et est égal à (n-r),

des moyens (36, 38, 46, 48, 44, 32) pour relier les bascules du registre SERDES, de la chaîne et les bascules sélectionnées du registre d'extension en un anneau,

des moyens (6, 8, 20-W) pour écrire dans le registre SERDES séquentiellement les multiplets à charger dans la chaîne,

des moyens (26, 40) pour appliquer sélectivement aux bascules de l'anneau des impulsions d'horloge provoquant un décalage des bits dans l'anneau, une opération de chargement étant réalisée en chargeant en parallèle dans le registre SERDES les multiplets comportant les bits résiduels, et en provoquant un décalage de n bits dans l'anneau puis en chargeant successivement les k multiplets et en provoquant après chaque chargement un décalage de n bits.

2. Dispositif selon la revendication 1 utilisé pour lire les bits contenus dans une chaîne de bascules de longueur nk + r caractérisé en ce qu'il comporte des moyens (8, 20-R) pour lire le contenu du registre SERDES; une opération de lecture des bits contenus dans les bascules de la chaîne étant réalisée en provoquant un premier décalage de n bits dans l'anneau comportant les bascules du registre SERDES, les bascules de la chaîne à lire, et (n-R) bascules du registre d'extension et en lisant le contenu des bascules du registre SERDES et en provoquant k décalages successifs de n bits et en lisant après chaque décalage le contenu du registre SERDES.

3. Dispositif selon la revendication 2 caractérisé en ce qu'il est utilisé pour charger et lire les chaînes de bascules constituées dans une unité de traitement de données afin de réaliser les opérations d'initialisation et de test de l'unité.

4. Dispositif selon la revendication 3 caractérisé en ce que les moyens pour écrire et lire les multiplets dans le registre SERDES comportent un microprocesseur (8) associé à une mémoire (6) dans laquelle une zone est réservée à chaque chaîne de l'unité pour stoker les configurations de bits à envoyer rangées par multiplets ainsi que le nombre de bits résiduels de la chaîne, ledit microprocesseur comportant:

un bus d'entrée/sortie (20) par lequel les bits stockés en mémoire sont transférés dans le registre SERDES par une opération d'écriture, les bits stockés dans le SERDES sont transférés au microprocesseur par une opération de lecture, et le nombre de bits résiduels est envoyé au moyen de sélection pour sélectionner les (n-r) bascules du registre d'extension,

une ligne d'adressage de chaîne (30) pour connecter en anneau la chaîne sélectionnée avec le registre SERDES et les bascules sélectionnées du registre d'extension,

une ligne de commande de décalage (28) pour contrôler aux instants appropriés l'application aux bascules de l'anneau de bascules constitué suite à l'adressage d'une chaîne du nombre d'impulsions d'horloge nécessaire à l'obtention des décalages de n bits.

5. Dispositif selon l'une quelconque des revendications 2 à 4 précédentes caractérisé en ce que les moyens de sélection comportent:

un registre (18) dans lequel est écrit le nombre de bits résiduels relatif à la chaîne à charger ou à lire,

un circuit de décodage (22), pour décoder le contenu dudit registre, ce circuit de décodage ayant n sorties (R0 à R7) et générant un signal actif sur l'une des sorties suivant le contenu du registre,

un circuit de sélection (24) recevant les sorties du circuit de décodage (22) pour mettre en série (n-r) bascules du registre d'extension.

**Patentansprüche**

1. Vorrichtung für die Serialisierung/Entserialisierung, um Bitkonfigurationen in Kippketten ungleicher Läge zu laden, gleich nk + r, wo n die Anzahl der Bits einer Bitkonfiguration k die Anzahl ganzer Bitkonfigurationen der Kette und r die Anzahl der Restbits kleiner n ist, dadurch gekennzeichnet, dass sie enthält:

ein Verschiebungsregister für die Serialisierung und Entserialisierung SERDES (14), n Kipps enthaltend, die parallel geladen werden können,

ein Erweiterungsregister (16) mit einer maximalen Anzahl von (n-1) Kipps,

Auswahlmittel (18, 22, 24), um im Erweiterungsregister ein Verschiebungsregister zu bilden, dessen Anzahl Kipps von der Länge der Kette abhängig und gleich (n-r) ist,

Mittel (36, 38, 46, 48, 44, 32), um die Kipps des Registers SERDES der Kette und die ausgewählten Kipps aus den Erweiterungsregister in einem Ring zusammenzufassen,

Mittel (6, 8, 20-W), um im SERDES-Register sequentiell die in die Kette zu ladenden Bitkonfigurationen zu schreiben,

Mittel (26, 40), um an die Kipps des Ringes Taktimpulse selektiv anzulegen, die eine Verschiebung der Bits im Ring bewirken, während ein Ladevorgang durch parallele Ladung der Bitkonfigurationen in das SERDES-Register ausgeführt wird, welche die Rest-Bits enthalten, und die eine Verschiebung um n Bits im Ring bewirken, während dann nacheinander die k Bitkonfigurationen geladen werden und nach jeder Ladung eine Verschiebung um n Bits hervorgerufen wird.

2. Vorrichtung gemäss Anspruch 1 zum Lesen der Bits, die in der Kette der Kipps der Länge nk + r enthalten sind, dadurch gekennzeichnet, dass sie Mittel (8, 20-R) zum Lesen des Inhalts des SERDES-Registers enthält; ein Lesevorgang der in den Kipps der Kette enthaltenen Bits wird durchgeführt durch Bewirkung einer ersten Verschiebung um n Bits im Ring, der die Kipps des SERDES-Registers, die Kipps der zu lesenden Kette und (n-R)-Kipps des Erweiterungsregisters enthält, und durch Lesen des Inhalts der Kipps des Registers SERDES, und durch Bewirkung von k aufeinanderfolgenden Verschiebungen um n Bits durch Lesen des Inhalts des SERDES-Registers nach jeder Verschiebung.

3. Vorrichtung gemäss Anspruch 2, dadurch gekennzeichnet, dass sie zum Laden und Lesen der Kippketten verwendet wird, die in einer Datenverarbeitungseinheit gebildet werden, um die Initialisierungs- und Testvorgänge der Einheit auszuführen.

4. Vorrichtung gemäss Anspruch 3, dadurch gekennzeichnet, dass die Mittel zum Schreiben und Lesen der Bitkonfigurationen im SERDES-Register einen Mikroprozessor (8) enthalten, der einem Speicher (6) zugeordnet ist, in dem eine Zone für jede Kette der Einheit reserviert ist, um die Bit-Konfigurationen abzulegen, die nach Bitkonfigurationen geordnet auszusenden sind, sowie die Anzahl der Restbits der Kette, wobei besagter Mikroprozessor enthält:

einen Ein- und Ausgangsbus (20), auf dem die im Speicher abgelegten Bits in das SERDES-Register übertragen werden, durch einen Schreibvorgang, während die im SERDES-Register gespeicherten Bits durch einen Lesevorgang an den Mikroprozessor übertragen werden, und die Anzahl der Restbits an das Auswahlmittel geleitet wird, um die (n-r)-Kipps des Erweiterungsregisters auszuwählen,

eine Adressierleitung der Kette (30), um die ausgewählte Kette mit dem SERDES-Register und den ausgewählten Kipps des Erweiterungsregisters zu einem Ring zu schliessen,

eine Verschiebungssteuerleitung (28), um zu den geeigneten Zeitpunkten das Anlegen einer Kette der Taktimpulszahl, die für die Erreichung der Verschiebungen um n Bits erforderlich ist, an die Kipps des nach dem Adressieren einer Kette gebildeten Ringes zu steuern.

5. Vorrichtung gemäss einem der vorangehenden Ansprüche 2, bis 4, dadurch gekennzeichnet, dass die Auswahlmittel enthalten:

ein Register (18), in dem die Anzahl Restbits eingetragen ist, welche die zu ladende oder zu lesende Kette betreffen,

ein Dekodierschaltung (22) zum Dekodieren des Inhalts des besagten Registers, wobei diese Dekodierschaltung n Ausgänge (R0 bis R7) besitzt, und ein Signal erzeugt, das an einem der Ausgänge wirksam wird, je nach dem Inhalt des Registers,

einer Wählschaltung (24), welche die Ausgänge der Dekodierschaltung (22) aufnimmt, um (n-r)-Kipps des Erweiterungsregisters in Serie zu bringen.

## Claims

1. A serializer/deserializer device for loading bit configurations into strings of latches of variable length nk + r, where n is the number of bits in a byte, k is the number of residual bits, with r being smaller than n, characterized in that it comprises:

a serializer/deserializer (SERDES) shift register (14) having n latsches that can be loaded in parallel,

an extension register (16) having a maximum of (n-1) latches,

selection means (18, 22, 24) for forming in said extension register a shift register the number of latches of which is dependent upon the length of the string and is equal to (n-r),

means (36, 38, 46, 48, 44, 32) for interconnecting the latches of the SIRDES register, those of the string and selected ones of the extension register latches to form a ring network,

means (6, 8, 20-W) for sequentially writing into the SERDES register the bytes to be loaded in the string, and

means (24, 40) for selectively applying to the latches in said ring, clock pulses causing the bits in the ring to be shifted, a write operation being performed by loading in parallel in the SERDES register, the bytes that includes the residual bits, by causing n bits to be shifted in the ring, by loading the k bytes in succession, and by causing n bits to be shifted after each loading step.

2. A device according to claim 1, used to read the bits contained in a string of latches of length nk + r, characterized in that it comprises means (8, 20-R) for reading out the contents of the SERDES register, the bits contained in the latches of the string being read out by performing a first shift of n bits in the ring comprising the latches of the SERDES register, the latches of the string to be read out and (n-r) latches of the extension register, by reading out the contents of the latches in the SERDES register, by causing k successive shifts of n bits to be performed and by performing a reading step after each shift of the contents of the SERDES register.

3. A device according to claim 2, characterized in that it is used for writing and reading data into and out of the strings of latches formed in a data processing unit in order to test and initialize said unit.

4. A device according to claim 3, characterized in that the means for writing and reading the bytes into and out of the SERDES register include a microprocessor (8) associated with a memory (6) an area of which is allocated to each string of the unit for storing the outgoing bit configurations arranged into bytes as well as the number of residual bits relating to the string, said microprocessor comprising:

an input/output bus (20) through which the bits stored in the memory are transferred to the SERDES register by means of a write operation, the bits stored in the SERDES register are transferred to the microprocessor by means of a read operation and the number of residual bits is sent to the selection means to select the (n-r) latches of the extension register,

a string address line (30) for interconnecting the selected string, the SERDES register and the selected latches of the extension register to form a ring network, and

a shift control line (28) for checking on appropriate times, the application of the number of clock pulses required to effect n-bit shifts, to the latches in the ring formed after a string has been addressed.

5. A device according to any one of claims 2 to 4, characterized in that the selection means includes:

a register (18) into which the number of residual bits for the string to be loaded or read out is written,

a decoding circuit (22) for decoding the contents of said register, said decoding circuit having n outputs (R0 to R7) and generating an active signal on one of the outputs depending on the contents of the register, and

a selection circuit (24) that receives the outputs from the decoding circuit (22) to cause (n-r) latches of the extension register to be connected in series.

FIG. 1

# FIG. 2

# FIG. 3

ETAPE I

FIG. 3A

ETAPE II

FIG. 3B

ETAPE III

FIG. 3C

ETAPE IV

FIG. 3D

ETAPE V

FIG. 3E

# FIG. 4

ETAT INITIAL

ETAPE I

# FIG. 4A

DECALAGE 8 BITS
LECTURE REG. 14

ETAPE II

# FIG. 4B

DECALAGE 8 BITS
LECTURE REG. 14

ETAPE III

# FIG. 4C

DECALAGE DE
8 BITS

ETAPE IV

# FIG. 4D

FIG. 5A

FIG.5